# EUROPEAN PATENT APPLICATION

(11) **EP 0 586 860 A2**
(43) Date of publication of application: **16.03.1994**
(21) Application number: 93112105.7
(22) Date of filing: 29.07.1993
(51) Int. Cl.: G03F 7/004, G03F 7/023

(54) **Photoresist composition and process for forming a pattern using the same**

(30) Priority: 09.09.1992 KR 1654892
(71) Applicant: SAMSUNG ELECTRONICS CO., LTD., Suwon-city, Kyungki-do 441-373 (KR)
(72) Inventor: Park, Chun-geun, Kwonsun-gu, Suwon-city, Kyungki-do (KR); Lee, Joong-hyun, Seodaemun-gu, Seoul (KR); Han, Woo-sung, Kwonsun-gu, Suwon-city, Kyungki-do (KR)
(74) Representative: Dauster, Hanjörg, Dipl.-Ing.

(57) **Abstract**

A photoresist composition comprises a novolac-based resin and polyvinylphenol-based resin, and process for patterning uses the photoresist composition, so that a 0.25µm-sized pattern having a good profile can be obtained and the linearity between pattern sizes is maintained satisfactorily to the pattern size of 0.25µm, wherein the novolac-based resin structure A and the polyvinylphenol-based resin structure B are 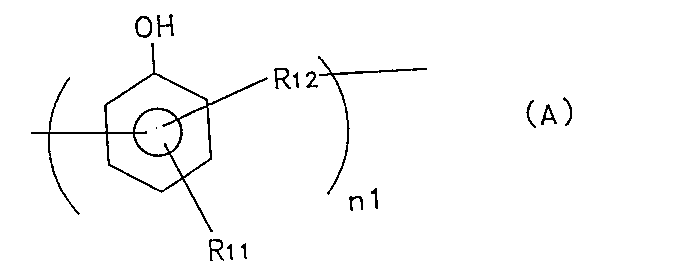 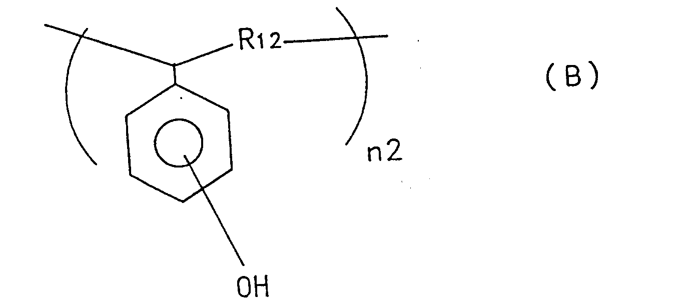 wherein R₁₁ represents hydrogen or C₁₋₆ alkyl group, R₁ represents C₁₋₆ alkylene, and n₁ and n₂ represent positive integers.

## Description

### Background of the Invention

The present invention relates to a photoresist composition and process for forming a pattern using the same, and particularly to a photoresist composition including two different kinds of resins and a process for forming a pattern using the same.

For fabrication of fine circuits, the implantation of impurities into a tiny region of silicon substrate and the inter-connection between these regions is necessary to form a device and VLSI circuits. Patterns for defining these regions are manufactured by a lithography process. That is, the lithography process includes the steps of coating a resist on the surface of a wafer substrate, selectively exposing the coated resist to ultraviolet rays, electron rays or X-rays and then developing the exposure. Here, the remaining resist protects the substrate which the resist covers, while various additive or substractive process are performed on the exposed substrate.

As semiconductor devices acquire greater packaging density, continued development has proceeded with respect to lithography processing for manufacturing fine resist patterns with critical dimensions. i.e., below sub-micron. The conventional single layer resist has turned out to be unsuitable for manufacturing patterns having sub-micron dimensions, especially for currently developed DRAMs having more than one megabit capacities.

The resolution a planner substrate is determined by the exposure contrast and the lithographic contrast of the resist. Accordingly, in order to manufacture micron and sub-micron patterns with high resolution, high-contrast resists and a good exposing apparatus should be used. In such a case, the difference of the exposure dosage which is in accordance with the light absorbance of the resist owing to the difference of the resist thickness, and the inherent factors of optical lithography such as the reflectance from the substrate, the light scattering, etc. become the factors which lower the resolution. Besides the problem of resolution, heat stability and resistance against dry etching are necessary as a masking characteristic and the resist should have a thickness of at least 1 am.

In order to solve the above-mentioned problems, a multi-layer resist process has been proposed and, here, the use of a tri-layer resist structure achieved good results. However, this multi-layer process also has problems in that the process is complicated, a film and an inter-layer are liable to receive stress during a baking step. Also, forming a thin and even resist without pin holes via coating is difficult.

To reduce the complexity of the multi-layer system, double-layer system including silicon-containing resist has been developed. However, more than 10% of silicon should be contained in the resist, which deteriorates physical and chemical properties of the resists. Therefore, the double-layer system is rarely used nowadays.

A diffusion-enhanced silylated resist (DESIRE) process which includes both the functionality of the multi-layer and the simplicity of the single layer, has been proposed and is being regarded as a preferable solution (see F. Coopmans and B. Roland. Solid State Technology, June 1987, pp 93-99). Silylation is a process whereby silicon is incorporated into a resist polymer by exposing the material to a gaseous or liquid-silicon-containing compound, such as hexamethyldisilazane (HMDS) or Tetramethyldisilazane(TMDS), at a high temperature (100-200 _{°} C). The DESIRE process is characterized in that the latent optical image is transformed into a latent silicon image by a highly selective gaseous silylation. This silicon image is used to produce a relief image by dry etching in oxygen.

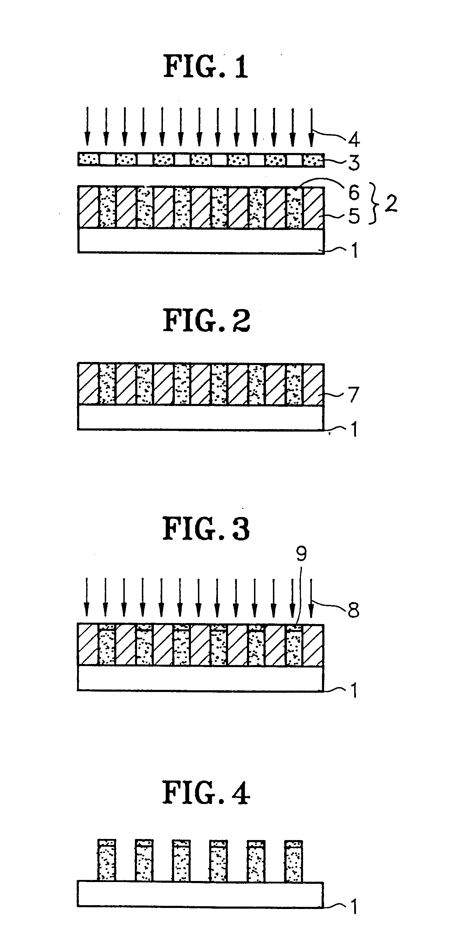

Fundamental steps of the DESIRE process will be described by referring to the attached FIG. 1 to FIG. 4.

First, a resist layer 2 is formed by coating a novolac-based photoresist resin on a wafer 1. Next, resist layer 2 is exposed to ultraviolet rays 4 using a photo mask 3 on which a mask pattern is formed. Then, resist layer 2 is divided into an exposed portion 6 and an unexposed portion 5. The photosensitive compound in exposed portion 6 of resist layer 2 dissociates so that -OH groups of molecules in the resist resin become free (FIG.1).

Then, resist layer 2 is baked at a temperature above 140 _{°} C (FIG.2). Through this baking, the resin particles in unexposed portion 5 of resist layer 2 cross-links with the photosensitive compound to form a polymer layer 7. This process is called a pre-silylation bake (or PSB) process.

Next, silicon-containing compounds such as HMDS or tetramethyldisilazane (TMDS) is introduced over the resist layer in a gaseous state. Then, the resin particles in exposed portion 6 of resist layer 2 selectively react with silicon in the HMDS or TMDS to form a silylated resist layer 9. This is called a silylation process (FIG.3).

Next, the resist layer is dry-developed using oxygen plasma to form a resist pattern (FIG.4). During dry development, the silicon in silylated resist layer 9 rapidly combines with oxygen to form a silicon dioxide layer which acts as a barrier. Therefore, the resist under silylated resist layer 9 is not removed, while the other portion of the resist is removed to form a resist pattern. The dry development is generally carried out by reactive-ion-etching (RIE) and is otherwise called resist etching.

Performing the above fundamental four steps of coating-exposing-silylation-developing produces a relief image having a negative tone. As described above, the process for forming a relief image having a negative tone using the novolac-based photoresist is called a negative tone process.

Meanwhile, the negative relief image obtained through the negative tone process can be formed using a chemical amplification resist containing a cross-linking agent. In this process, a cross-linked polymer layer is formed on the exposed portion of the resist layer and a silylation layer is formed on the surface of the resist of the unexposed portion. Thus, the reversed relief image is obtained. This is known as a positive tone process.

A process for generating the above-mentioned positive tone photoresist in an oxygen plasma is disclosed in U.S. Patent No. 4,657,845. According to the above patent, a polymer containing a masked reactive functionality is coated on a substrate, and then exposed to radiation. The polymer is processed in an imagewise manner to unmask selected portions of the reactive functionality. Then, the polymer is treated with a non-organometallic reagent which reacts with the unmasked reactive functionality to remask that functionality. Following flood exposure, the resist is treated with organometallic reagents containing an element which forms a non-volatile oxide, and developed by means of oxygen reactive-ion-etching. In the above patent, as an organometallic species, silicon compounds such as hexamethyldisilazane. N,N-dimethylaminotrimethylsilane etc., or a tin compound is used.

However, according to the above-mentioned process, in order to form a positive tone resist pattern, a positive tone functional photoresist should be used and complicated processes such as alkaline treatment, flood exposure, etc. are necessary.

Though fine patterns can be formed by the above DESIRE process, several problems exist. It is difficult to control the reaction because the silylation reaction is carried out in a gaseous phase and this makes it difficult to form an uniform silylated layer on the surface portion of the resist. As the width of the pattern reduces, a resist residue is unpreferably formed around the pattern owing to the undesirable parasitic exposure due to the diffraction of the light. Moreover, since the molecules of the silylating agent penetrates into the resist layer and reacts with the molecules of the resist, the resulting swelling phenomena makes it difficult to form a desired pattern, and controlling the resist strip is very difficult.

Meanwhile, for the fabrication of VLSI circuits with critical dimensions of below a half-micron, a new chemical amplification resist system has been developed which has an enhanced photosensitivity to ultraviolet radiation (200-300nm). In this system, during exposure, a photosensitive acid generator (hereinafter referred to as a "PAG") decomposes and initially produces an acid. Then, an acid-catalyzed heat reaction occurs, to thereby render the exposed portion of the resist soluble in the case of positive resists, and insoluble in the case of negative resists.

Recently disclosed was a process for forming a pattern using a tri-component system comprised of a PAG, an acid-labile dissolution controlling material and a novolac resin. According to the above process, tri-(methansulfonyloxy)benzene (MeSB) was used as the PAG, and polyhydroxystyrene protected with the tetrahydropyranyl group (THP-M) was used as the acid-labile dissolution controlling material. Here, the thickness of the formed resist layer was 0.7u.m. Exposing the resist layer with a KrF excimer laser stepper (manufactured by Nikon Co.), and then developing, produced a 0.3µm pattern. The acid-labile dissolution controlling material is known as a dissolution inhibitor. Examples thereof include bisphenol-A protected with tetrahydropyranyl group (THP-BA), bisphenol-A protected with tert-butoxycarbonyl group (tBOC-BA), bisphenol-A protected with trimethylsilyl group (TMS-BA), the above-mentioned THP-M, etc.

Patterns having a size of 0.3µm may be formed by using the above photoresist composition. As the packaging density of a semiconductor device increases, patterns smaller than 0.3µm because necessary, especially for 64Mb and 256Mb DRAMs. However, resist patterns below 0.3µm are not easy to form by the above conventional process. Further, when performing the DESIRE process using the above photoresist composition, since the conventional photoresist composition comprises, as a main component, a single polymer for both positive tone and negative tone processes, reactivity differs according to pattern sizes, and therefore, not only could the linearity not be obtained for patterns smaller than 0.30tim, but also simultaneous formation of both patterns smaller than 0.30tim and larger than 0.50tim was difficult.

Therefore, research on improving the DESIRE process for forming resist patterns suitable for 64Mb or 256Mb DRAMs have been carried out.

The present inventors have discovered that using a resist composition prepared by mixing resists having different silylating reactivies, uniformly controls the silylation reaction and produces patterns having good linearity in spite of varying sizes. The present invention has been accomplished as a result of this discovery.

### Summary of the Invention

Therefore, an object of the present invention is to provide a photoresist composition which can produce resist patterns having sizes smaller than 0.3µm and having a good linearity using the DESIRE process or the conventional developing process.

Another object of the present invention is to provide a process for forming a pattern using the above-mentioned photoresist composition.

To accomplish the object of the present invention, there is provided a photoresist composition comprising a novolac-based resin having the following structure A and a polyvinylphenol-based resin having the following structure B: 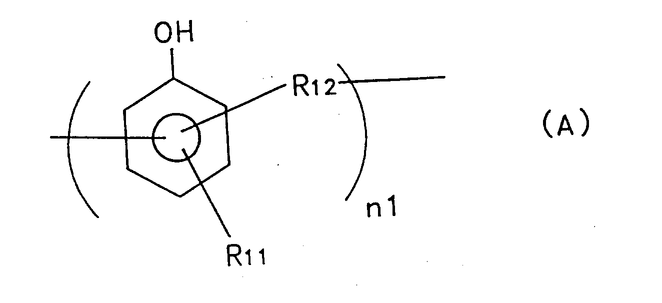 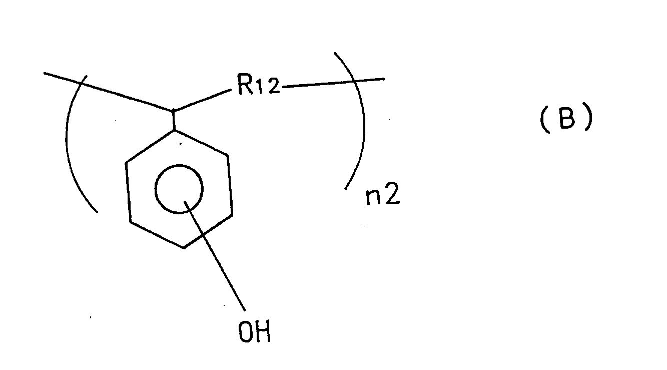
wherein R₁₁ represents hydrogen or C₁₋₆ alkyl group, R₁ represents C₁₋₆ alkylene group, and ni and n₂ represent positive integers.

To accomplish another object of the present invention, there is provided a process for photoresist patterning comprising the steps of: coating on the semiconductor wafer to form a resist layer with a photoresist composition including novolac-based resin having the following structure A, and polyvinyl phenol- based resin having the following structure B: 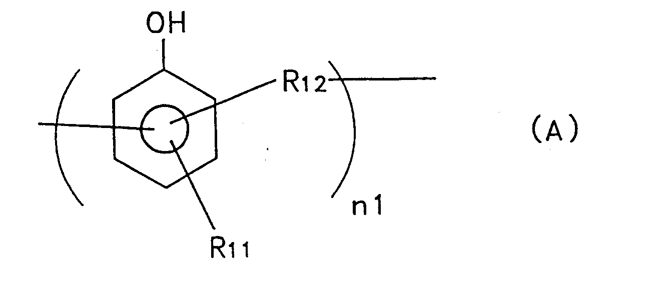 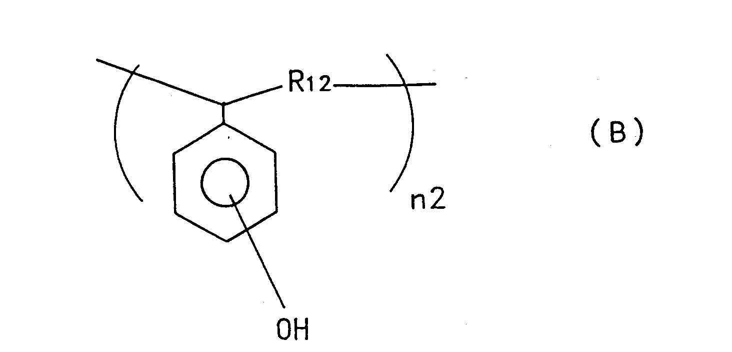
wherein R11 represents hydrogen or C, -₆ alkyl group, R₁₂ represents C, -₆ alkylene, and ni and n₂ represent positive integers; selectively exposing the resist layer using a photo mask; selectively silylating a portion of the resist layer to form a silylated resist layer on the surface of the resist layer; and removing the un-silylated resist layer, while leaving resist under the silylated resist layer.

Optimization of the silylation process is performed prior to the developing process by properly mixing more than two kinds of resins having different molecular structures and different molecular weights. When forming a pattern using the photoresist composition according to the conventional DESIRE process, a 0.25µm-sized pattern having a good profile can be obtained. Also, the linearity between pattern sizes is maintained satisfactorily to the pattern size of 0.25µm. Therefore, patterns having sizes of 0.25µm and larger can be simultaneously obtained.

### Brief Description of the Drawings

The above objects and other advantages of the present invention will become more apparent by describing in detail a preferred embodiment thereof with reference to the attached drawings in which:
FIG. 1 to FIG .4 illustrate schematic views of the fundamental steps for a conventional DESIRE process.
FIG.5 to FIG.8 are SEM pictures of resist patterns manufactured by Example 1 of the present invention.
FIG.9, FIG.10 and FIG.11 are SEM pictures of resist patterns manufactured by Example 2 of the present invention.
FIG.12 is a graph representing the observed size of a manufactured pattern with respect to the design size of the pattern.
FIG.13 to FIG.16 are SEM pictures of resist patterns manufactured by Comparative example 1.

### Detailed Description of the Invention

The novolac-based resin and the polyvinylphenol-based resin are known as being used as photoresists. However, the conventional photoresist comprises a single resin as a main component. When forming a photoresist pattern using the DESIRE process, the molecules of the photoresist resin should contain therein a functional group such as -OH. This functional group reacts with a silylating agent to selectively form a silylated resist layer on the surface of the resist layer during the above silylation. The silylated resist layer plays the role of an etching mask when forming a photoresist pattern by a dry etching using 0₂ plasma. The silylation factors include the used reagents such as a photosensitive agent (for example, the PAG), silylation agent, etc. and the type and structure of photoresist.

Since the conventional photoresist compositions employ single resins, silylation cannot be optimized regardless of which photoresist composition is used. When forming photoresist patterns without the silylation process, a photoresist composition comprising a single resin is preferable since the developing step may be performed consistently without difficulty.

However, according to the DESIRE process, the optimization of the silylation process by controlling of the silylation is necessary because silylation is performed prior to the developing process. In the present invention, the reaction process is optimized by properly mixing more than two kinds of resins having different molecular structures and different molecular weights. That is, resins having higher silylation reactivity and counterpart resins having lower silylation reactivity than a predetermined (or ideal) value are effectively selected and mixed. The reactivity of the resins are dependent on the type of resins used and the silylating agent. The quantities of the compounds are determined by comparing the relative yields after silylation, by means of a spectrometer such as an FT-IR. The numerical values of the silylation reactivity are determined by quantizing the relative variation of the Si-H or Si-O, and Si-C peaks after silylation of the resist by means of the above spectrometer.

The photoresist composition of the present invention comprises, as a main component, a novolac-based resin having the following structure A and a polyvinylphenol-based resin having the following structure B: 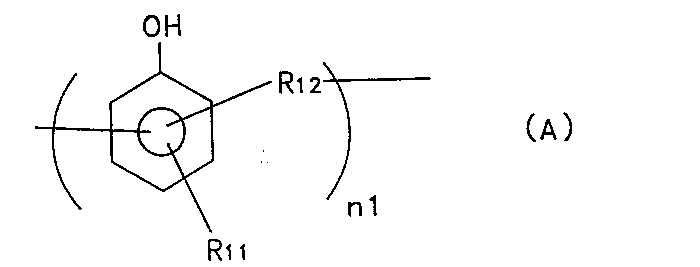 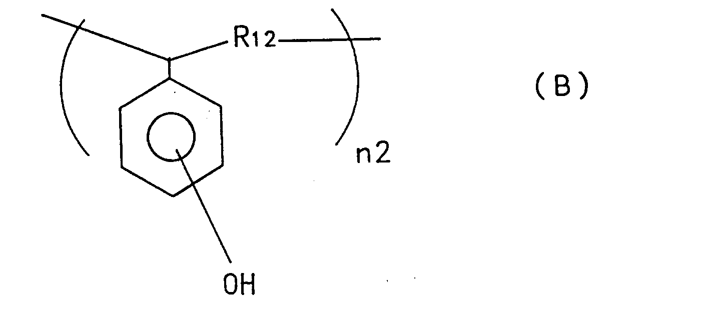
wherein R11 represents hydrogen or C, -₆ alkyl, R₁₂ represents C, -₆ alkylene, and nᵢ and n₂ represent positive integers.

According to a preferred embodiment of the present invention, the mixing ratio of the novolac-based resin and the polyvinylphenol-based resin ranges from 9:1 to 1:9 by weight. If the mixing ratio is beyond the above range, the obtained resist patterns are worse than the patterns formed using the single resins. The weight-average molecular weight of the novolac-based resin preferably ranges from about 1,000 to 30,000 and the weight-average molecular weight of the polyvinylphenol-based resin preferably ranges from about 2,000 to 150,000.

The photoresist composition of the present invention may further include additives according to a process for forming a pattern, i.e. whether it is a positive or negative tone process.

For example, in the case of employing a positive tone process as the pattern formation process, the photoresist composition of the present invention may include a PAG compound and cross-linking agents.

As a PAG compound which can be used in the present invention, onium salts, DDT, S-triazine derivatives, nitrobenzyl sulfonate, and aryl or alkyl sulfonic acid esters of phenol derivatives may be included. Among these, 1,2,3-tris(methanesulfonyloxy)benzene is preferably employed. The added amount of the PAG compound is preferably not more than 10% by weight, more preferably from 3 to 7% by weight, and most preferably, 5% by weight, based on the total weight of the photoresist composition comprised of the novolac-based resin and the polyvinylphenol-based resin.

As a cross-linking agent which can be used in the present invention, melamine or benzyl alcohol derivatives may be included. The added amount of the cross-linking agent preferably ranges from 10 to 30% by weight, and more preferably, 15% by weight, based on the total weight of the photoresist composition comprised of the novolac-based resin and the polyvinylphenol-based resin.

In the case of forming a resist pattern by the negative tone process, the photoresist composition of the present invention may include a photoactive compound (PAC) or both a PAG compound and a dissolution inhibitor (which are mentioned above). Examples of the PAC include diazonaphtoquinones and others.

The process for forming a photoresist pattern according to the present invention comprises the steps of: coating the above-mentioned photoresist composition on a semiconductor substrate to form a resist layer, selectively exposing the resist layer to a radiation, silylating an exposed portion of the resist layer to form a silylated resist layer on the surface portion of the resist layer, and then removing a portion of the un-silylated resist layer, while leaving the resist under the silylated resist layer. The process of the present invention can be carried out by a negative tone process in which an exposed portion of the resist layer is selectively silylated, or by a positive tone process in which an unexposed portion of the resist layer is selectively silylated.

As a silylating agent used in the present invention, hexamethyldisilazane, tetramethyldisilazane, dimethylsilyldimethylamine, dimethylsilyldiethylamine, trimethylsilyldimethylamine, trimethylsilyldiethylamine, dimethylaminotrimethylsilane, diethylaminotrimethylsilane, bis(dimethylamino)dimethylsilane, bis(dimethylamino)methylsilane, octamethylcyclotetrasilazane, hexamethylcyclotrisilazane, dichlorooc- tamethylcyclotetrasiloxane, dichlorodimethyldiphenyldisiloxane, tetramethyldisilazacyclopentane, tetramethyl-bis(N,N-dimethylamino)disilethylene, bis(trimethylsilyl)acetamide, or other organic metal reagents containing silicon may be included.

The removing step of the un-silylated portion of the resist excluding the resist under the silylated resist layer can be carried out by a one-step process using 0₂ plasma or by a two-step process comprising the steps of partially etching the un-silylated resist and silylated resist using a CF₄ and 0₂ system during a first stage, and then etching using 0₂ plasma during a second stage.

Generally, when exposing a photoresist, the resist near the patterns tends to be parasitically exposed owing to light diffraction. The parasitically exposed resists are silylated during silylation and act as an etching mask during the resist etching step, and accordingly produce a bad profile during resist etching, and after the resist etching, produce a residue between the patterns, which adversely affects a subsequent process. Therefore, a two-step process of the removing of the un-silylated resist is preferably carried out by etching about from 10nm to 30nm of both the silylated and un-silylated resist layer using CF₄ and 0₂ plasma during a first stage, and then etching the resultant using 0₂ plasma during a second stage.

Another process for forming a photoresist pattern according to the present invention comprises the steps of: coating the above photoresist composition on the semiconductor substrate to form a resist layer, selectively exposing the resist layer using a photo mask, developing the exposed resist layer to form a resist pattern. The photoresist composition may further include the PAG compound and cross-linking agent in the case of forming the resist pattern by the negative tone process. Also, the photoresist composition may further include the PAC or both the PAG compound and the dissolution inhibitor in the case of forming the resist pattern by the positive tone process. The amounts of the above-mentioned additives are the same as described above. As a developer, a mixture solution containing 1.5 to 3wt% of tetramethyl ammonium hydroxide (TMAH) in deionized water can be used.

Hereinafter, the present invention will be described in more detail with reference to the following examples.

### Example 1

### Preparation of the Photoresist Composition

A photoresist composition was prepared by mixing novolac-based resin having a weight-average molecular weight of about 5,000 with polyvinylphenol resin having a weight-average molecular weight of about 40,000 at the mixing ratio of 3:1 by weight. To the composition, 5% by weight of tris-(methanesulfonyloxy)benzene as a PAG compound and 15% by weight of melamine as a cross-linking agent based on the total weight of the thus-obtained photoresist composition were added to obtain the photoresist composition including the additives.

### Resist Patterning

The resist patterns of the present invention using the thus-obtained photoresist composition including the additives were formed as follows.

A photoresist solution was prepared by dissolving the above-obtained photoresist composition in diethyleneglycol dimethyl ether as a solvent. The resist solution was spin-coated on a semiconductor wafer to a thickness of about 1µm and then soft-baked at a temperature of about 90 _{°} C for one minute, to thereby give a photoresist layer.

Next, the photoresist layer was selectively exposed using a photo mask having respective line widths of 0.25tim, 0.30tim, 0.35tim and 0.40µm according to a design rule and using a KrF excimer laser stepper with a numerical aperture of 0.45.

The exposed photoresist layer was silylated using TMDS as a silylating agent at a temperature of about 100 _{°} C. Then, the -OH in the resin reacted with the silylating agent to transform -Ph-O-Si-(Me)₂ H. This reaction can be detected by using the FT-IR.

After the silylating, the resist layer was developed using an 0₂ plasma resist etching apparatus model BMC-600 (manufactured by MRC Co.) which employs a magnetic-enhanced reactive-ion-etching (MERIE) method, in the same manner as described in the aforementioned U.S. patent (No. 4,657,845), to thereby form photoresist patterns.

Here, the unexposed surface portion of the resist layer became silylated resist layer, and was more etching-resistant to the 0₂ plasma treatment when compared to the exposed cross-linked photoresist. That is, in the 0₂ plasma treating, the silylated resist layer transformed into SiOₓ which is etching-resistant to the 0₂ plasma etching and remained as patterns after the 0₂ plasma treatment and the un-silylated exposed resist was removed by 0₂ plasma, to thereby form a positive tone pattern.

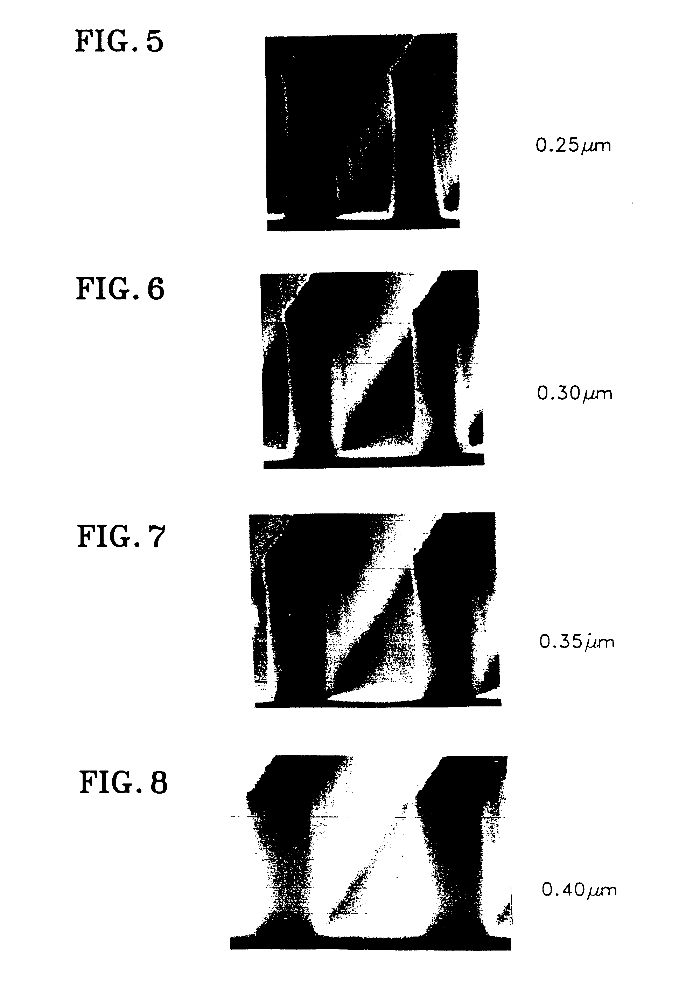

FIG.5 to FIG.8 are SEM pictures of resist patterns manufactured by Example 1. As can be seen from the SEM pictures, when forming the resist patterns by using the photoresist composition of the present invention. 0.25am-, 0.30am-, 0.35µm- and 0.40µm-sized patterns having good profiles were obtained.

### Example 2

Positive tone photoresist patterns having 0.30µm, 0.34µm and 0.40µm sizes were formed by following the same procedure as described in Example 1, except that the photoresist composition prepared by mixing the novolac-based resin with the polyvinylphenol resin at a mixing ratio of 1:4 instead of 3:1 was used.

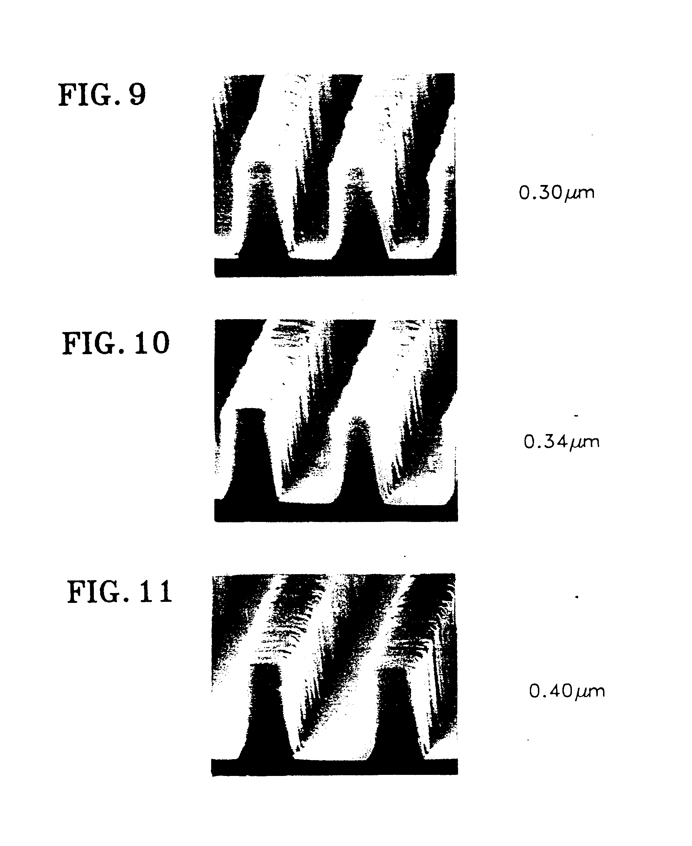

FIG.9 to FIG.11 are SEM pictures of resist patterns manufactured by Example 2. As can be seen from the SEM pictures, 0.30µm-, 0.34µm- and 0.40µm-sized patterns having good profiles were formed by using the photoresist composition of the present invention.

### Example 3

A photoresist layer was formed on a semiconductor wafer using the same photoresist composition employed in Example 1 in the same manner as in Example 1. The resist layer was exposed with a photo mask and then developed using as a developer a mixed solution containing 1.5 to 3wt% of TMAH in deionized water, to form a negative tone photoresist patterns.

The pattern profile was observed through an electron microscope and was found that resist patterns having profiles the same as those formed in Example 1 were formed.

### Example 4

A photoresist layer was formed on a semiconductor wafer in the same procedure as in Example 1, except that a photoresist composition containing 20% by weight of a diazonaphtoquinone (based on the resin mixture) as a PAC was employed instead of using the PAG compound and cross-linking agent. A positive tone photoresist patterns were formed by exposing the resist layer by means of a photo mask and then developing with a mixed solution (as a developer) containing 1.5 to 3% by weight of TMAH in deionized water.

The pattern profile was observed through an electron microscope and was found that resist patterns having profiles the same as those formed in Example 1 were formed.

### Example 5

Positive tone photoresist patterns were formed in the same manner as in Example 1, except that, first, the un-silylated resist layer and silylated resist layer were etched using fifteen SCCM of CF₄ and fifteen SCCM of 0₂ to a thickness of about 10nm to 20nm for fifteen seconds during a first stage and then the resist under the un-silylated resist layer was etched using 0₂ plasma during a second stage, instead of etching the un-silylated exposed resist using 0₂ plasma.

According to this example, the parasitically silylated resist formed in the parasitically exposed resist which was formed during the resist layer exposure, was removed at the first etching stage. It was found that the resist patterns obtained in this example had better and more clear profiles than those obtained in Example 1 wherein a one-step etching was performed.

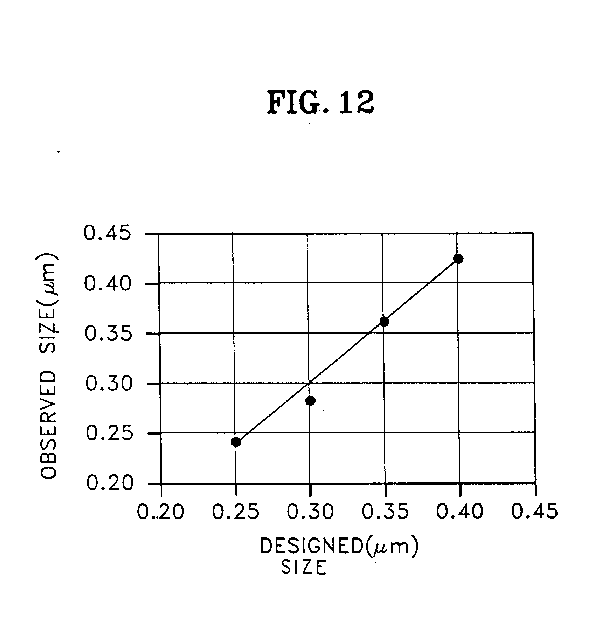

FIG.12 is a graph representing the observed size of the patterns obtained according to a process of the present invention using the photoresist composition of the present invention with respect to the designed size of the pattern. In this graph, the abscissa represents the designed size of the patterns and the ordinate represents the observed size of the patterns. From this graph, it is noted that the linearity between the pattern sizes is maintained satisfactorily to the pattern size of 0.25tim.

### Comparative example 1

Photoresist patterns were formed by following the same procedure as described in Example 1, except that a photoresist composition was prepared by mixing the novolac-based resin having a molecular weight of about 5,000 with the polyvinylphenol resin having a molecular weight of about 40,000 at a ration of 10:1 instead of 3:1.

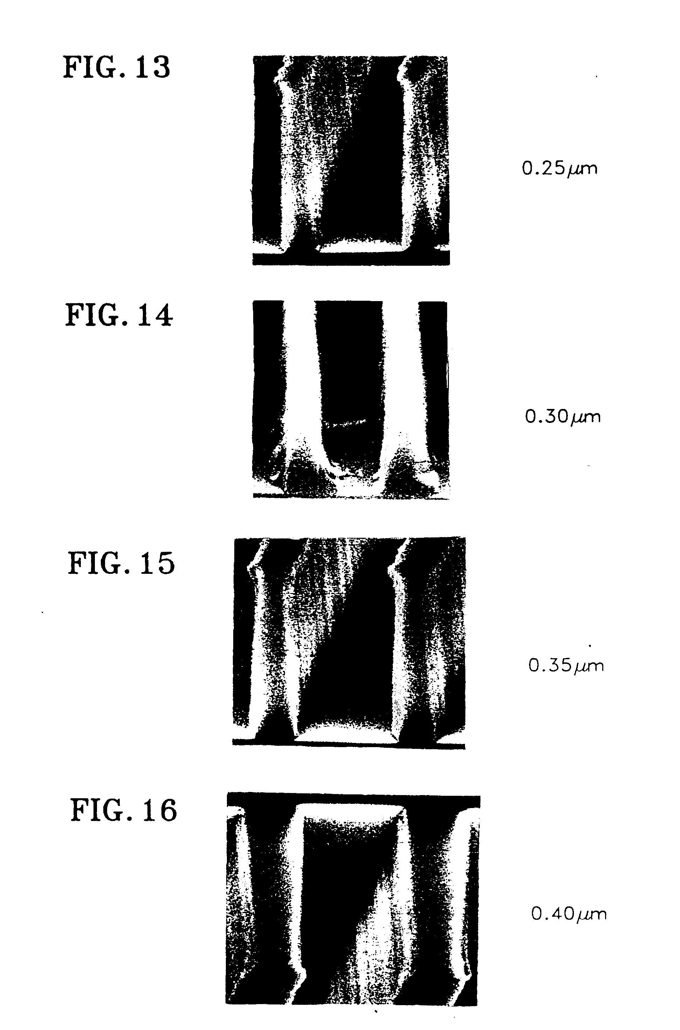

FIGs.13 to 16 are SEM pictures of resist patterns manufactured in this comparative example. Patterns of 0.25tim and 0.30µm were difficult to form. Also, the etching procedure was disturbed by the resist residues between the patterns, and pattern profiles of 0.35µm and 0.40µm were less than desirable, as can be seen from the pictures.

### Comparative example 2

Resist patterns were formed by following the same procedure described in Example 1 except that using a photoresist composition prepared using a single resin which is either novolac-based resin having a molecular weight of about 5,000 or a polyvinylphenol resin having a molecular weight of 40,000.

The resist patterns having good profiles could not be obtained as in Comparative example 1.

In Comparative examples 1 and 2, the linearity of patterns smaller than 0.30µm were unobtainable. Moreover, due to the difference in silylation degree according to pattern size, patterns smaller than 0.30µm and larger than 0.50µm could not be formed simultaneously.

In conclusion, in the present invention, as known from the examples and the comparative examples, patterns having a good profile could be obtained up to 0.25µm. Also, 0.25µm patterns and larger could be simultaneously obtained because the linearity of the patterns was maintained to 0.25µm.

While the present invention has been particularly shown and described with reference to particular embodiments thereof, it will be understood by those skilled in the art that various changes in form and details may be effected therein without departing from the spirit and scope of the invention as defined by the appended claims.

## Claims

1. Photoresist composition comprising:
novolac-based resin of the following structure A; and
polyvinylphenol-based resin of the following structure B 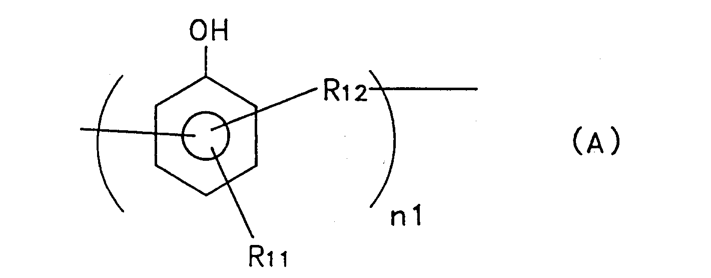 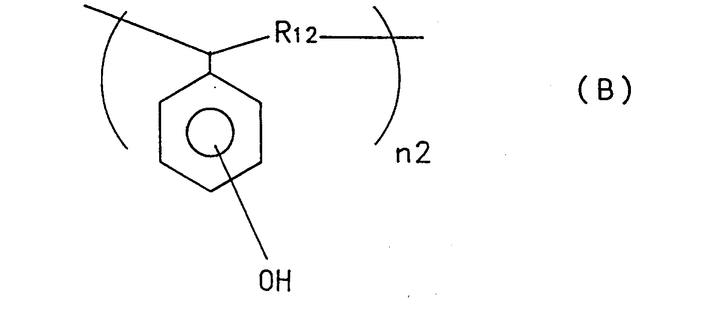
wherein R₁₁ represents hydrogen or C, -₆ alkyl group, R₁ represents C, -₆ alkylene, and ni and n₂ represent positive integers.

2. The photoresist composition as claimed in claim 1, wherein a mixing ratio of said novolac-based resin and said polyvinylphenol-based resin ranges from 9:1 to 1:9 based on the total weight of said two resins.

3. The photoresist composition as claimed in claim 1, wherein the weight-average molecular weight of said novolac-based resin ranges from 1,000 to 30,000.

4. The photoresist composition as claimed in claim 1, wherein the weight-average molecular weight of said polyvinylphenol-based resin ranges from 2,000 to 150,000.

5. The photoresist composition as claimed in claim 1, wherein said photoresist composition further comprises a photosensitive acid generator compound and a cross-linking agent.

6. The photoresist composition as claimed in claim 5, wherein said photosensitive acid generator compound is at least one compound selected from the group consisting of onium salt, DDT, S-triazine derivatives, nitrobenzyl sulfonate, and aryl or alkyl sulfonic acid esters of phenol derivatives.

7. The photoresist composition as claimed in claim 5, wherein said cross-linking agent is at least one compound selected from the group consisting of melamine and benzyl alcohol derivatives.

8. The photoresist composition as claimed in claim 1, wherein said photoresist composition further comprises a photoactive compound or both a photosensitive acid generator compound and a dissolution inhibitor.

9. The photoresist composition as claimed in claim 8, wherein said photoactive compound is diazonaphtoquinone.

10. A process for forming a pattern comprising the steps of:
coating on the semiconductor wafer to form a resist layer a photoresist composition including novolac-based resin of the following structure A, and polyvinylphenol-based resin of the following structure B 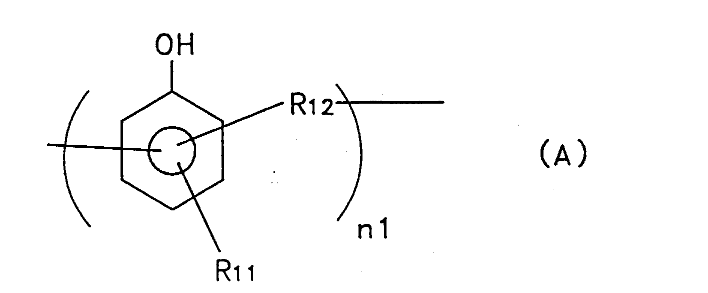 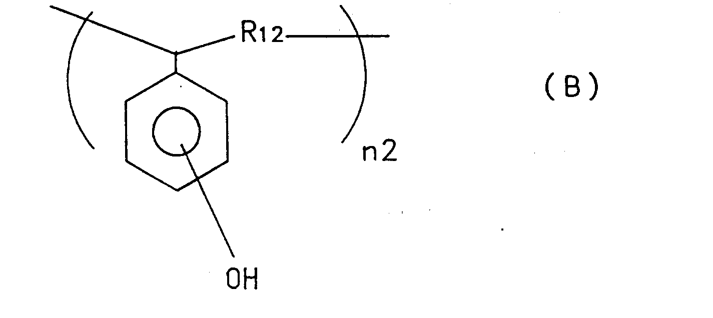
wherein R₁₁ represents hydrogen or C, -₆ alkyl group, R₁ represents C, -₆ alkylene, and ni and n₂ represent positive integers:
selectively exposing said resist layer using a photo mask;
selectively silylating the exposed resist layer to form a silylated resist layer on a surface portion of said resist layer; and
forming a pattern by removing a portion of the un-silylated resist, while leaving the resist under said silylated resist layer.

11. The process as claimed in claim 10, wherein said process is negative tone process in which said exposed portion of said resist layer is selectively silylated to form said silylated resist layer.

12. The process as claimed in claim 10, wherein said process is positive tone process in which an unexposed portion of said resist layer is selectively silylated to form said silylated resist layer.

13. The process as claimed in claim 11, wherein said silylating is performed by using at least one silylating agent selected from the group consisting of hexamethyldisilazane, tetramethyldisilazane. dimethylsilyldimethylamine, dimethylsilyldiethylamine, trimethylsilyldimethylamine, trimethylsilyldiethylamine, dimethylaminotrimethylsilane, diethylaminotrimethylsilane, bis(dimethylamino)dimethylsilane, bis-(dimethylamino)methylsilane, octamethylcyclotetrasilazane, hexamethylcyclotrisilazane, dichlorooc- tamethylcyclotetrasiloxane, dichlorodimethyldiphenyldisiloxane, tetramethyldisilazacyclopentane, tetramethyl-bis(N,N-dimethylamino)disilethylene, bis(trimethylsilyl)acetamide and organic metal reagents containing silicon.

14. The process as claimed in claim 11, wherein said un-silylated resist is removed by using 0₂ plasma.

15. The process as claimed in claim 11, wherein said pattern forming step is performed by a process comprising the steps of:
partially etching a portion of un-silylated resist and a portion of silylated resist simultaneously, using CF₄ and 0₂ plasmas, and then
etching the rest un-silylated resist by using 0₂ plasma.

16. A process for photoresist patterning comprising the steps of:
coating on the semiconductor wafer to form a resist layer a photoresist composition including: novolac-based resin of the following structure A, and polyvinylphenol-based resin of the following structure B 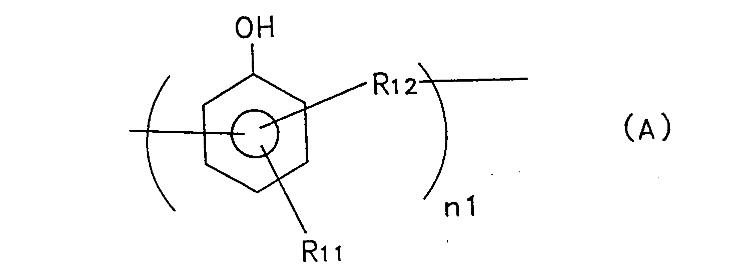 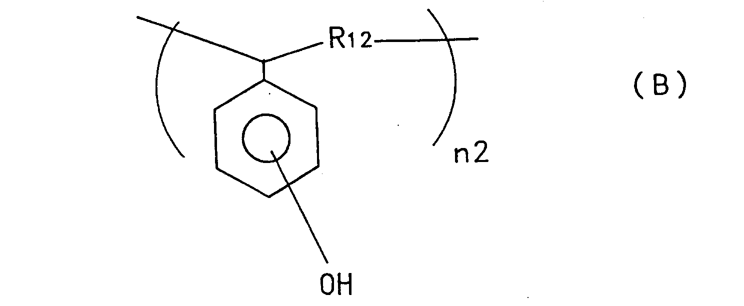
wherein R₁₁ represents hydrogen or C₁₋₆ alkyl group, R₁ represents C₁₋₆ alkylene, and ni and n₂ represent positive integers:
selectively exposing said resist layer using a photo mask; and
developing said exposed resist layer to form a resist pattern.

17. The process as claimed in claim 16, wherein said photoresist composition further comprises a photosensitive acid generator compound and cross-linking agents.

18. The process as claimed in claim 16, wherein said photoresist composition further comprises a photoactive compound.

19. The process as claimed in claim 16, wherein said developing is carried out by using a mixed solution, as a developer, containing 1.5 to 3wt% of tetramethyl ammonium hydroxide in deionized water.
